Europäisches Patentamt

European Patent Office

Office européen des brevets

(11) Veröffentlichungsnummer : **0 171 634**
**B1**

(12) **EUROPÄISCHE PATENTSCHRIFT**

(45) Veröffentlichungstag der Patentschrift :
26.04.89

(21) Anmeldenummer : 85108919.3

(22) Anmeldetag : 16.07.85

(51) Int. Cl.⁴ : **H 03 H 11/26**, G 01 S 7/52

(54) Verfahren und Vorrichtung zur Verzögerung eines ultraschallsignals.

(30) Priorität : 30.07.84 DE 3428046

(43) Veröffentlichungstag der Anmeldung :
19.02.86 Patentblatt 86/08

(45) Bekanntmachung des Hinweises auf die Patenterteilung : 26.04.89 Patentblatt 89/17

(84) Benannte Vertragsstaaten :
AT DE FR GB NL

(56) Entgegenhaltungen :
FR-A- 2 131 551
US-A- 3 196 406
THE JOURNAL OF THE ACOUSTICAL SOCIETY OF AMERICA, Band 71, Nr. 2, Februar 1982, Seiten 395-401, New York, US; R.C. HIGGINGS: "Quadrature receivers connected in parallel to improve detection performance in a multipath environment"

(73) Patentinhaber : Siemens Aktiengesellschaft Berlin und München
Wittelsbacherplatz 2
D-8000 München 2 (DE)

(72) Erfinder : Hiller, Dietmar, Dr.
Löhestrasse 22
D-8520 Erlangen (DE)
Erfinder : Saugeon, Ulrich
Weltenburger Strasse 175
D-8500 Nürnberg (DE)

## Beschreibung

Die Erfindung betrifft ein Verfahren zur Verzögerung eines aus einem Trägersignal mit zugeordneter Hüllkurve bestehenden Ultraschallsignals, bei dem zwei aus dem Ultraschallsignal gebildete Teilsignale getrennt verzögert werden. Die Erfindung betrifft ebenfalls eine Vorrichtung zur Durchführung des Verfahrens. Die Erfindung ist insbesondere für den Einsatz bei einem Phased Array, Annular Array oder dynamisch fokussiertem Linear Array vorgesehen.

In der medizinischen Ultraschalltechnik, insbesondere bei einem Phased-Array-Gerät, bei einem Linear-Array-Gerät mit elektronischer Fokussierung bei einem Annular-Array-Gerät oder bei einem Curved-Array-Gerät, ist die Verzögerung empfangener Ultraschallsignale in unterschiedlichen Verarbeitungskanälen ein wesentliches Problem. Jeder Verarbeitungskanal verarbeitet dabei Ultraschallsignale von einem (oder mehreren) Ultraschallwandler (n) des betreffenden Arrays. Eine Vielzahl derartiger Ultraschallsignale, die z. B. mit einer Bandbreite von ca. 1 MHz in einem Frequenzbereich zwischen 3 und 5 MHz liegen, sind in kleinen Zeitabstufungen im Größenordnungsbereich von 0 bis 10 $\mu$sec oder sogar noch darüber zu verzögern. Die Verzögerung ist dabei bekanntlich so vorzunehmen, daß die unterschiedlichen Laufzeiten des Ultraschallechos von einem Zielpunkt zu den Ultraschallwandler-Elementen ausgeglichen werden.

Man hat dabei bisher unterschiedliche Wege beschritten, so z. B. die Anwendung der Surface-Acoustic-Wave-Technik (SAW), die von der Videotechnik her an sich bekannt ist. Dort werden aber Frequenzen zwischen 15 bis ca. 40 MHz verarbeitet, so daß die Anwendung dieser Technik im Ultraschallbereich ein Hochmischen der Ultraschallsignale in diesen höheren Frequenzbereich erforderlich macht. Nachteilig ist dabei, daß teuere und aufwendige Bauelemente benötigt werden und außerdem wegen der hohen Dämpfung der Signale Probleme beim Umsteuern von Filtern in diesem Frequenzbereich auftreten.

Auch aus dem Bereich der Videotechnik kommt die Charge Coupled Device-Technik (CCD). CCD-Bauelemente sind jedoch ebenfalls teuer und schwierig anzusteuern. Außerdem ergeben sich Störungen im Nutzsignal, die nur mit Schwierigkeiten herauszufiltern sind.

Die bei Ultraschall-Array-Geräten ebenfalls einsetzbaren digitalen Verzögerungstechniken haben allesamt den Nachteil, daß bei einem Frequenzbereich bis zu 5 MHz eine Abtastrate für die Empfangssignale in der Größenordnung von 15 bis 20 MHz erforderlich ist. Analog-Digital-Wandler mit dieser Eigenschaft sind aber teuer und arbeiten zudem ungenau.

LC-Verzögerungsleitungen sind heutzutage die gebräuchliche Lösung zum Verzögern von Ultraschallsignalen. Auch diese haben bei hohen Frequenzen von z. B. 5 MHz den Nachteil, daß sich relativ lange Verzögerungszeiten nur mit hohem technischen Aufwand realisieren lassen.

Weitere Lösungen zur Bewältigung des Problems der Verzögerung eines Ultraschallsignals sind in der DE-C-28 54 134 und in einer Veröffentlichung von G. F. Manes « A new delay technique with application to ultrasound phased array imaging systems, Ultrasonics, Sept. 1979, S. 225-119 » beschrieben. Dort wird das empfangene Ultraschallsignal, das im Bereich von 3 bis 5 MHz liegt, durch Zumischung einer Frequenz auf eine tiefere oder höhere Frequenzebene gebracht. Im Falle einer höheren Frequenzebene kann mit Hilfe der SAW-Technik verzögert werden. Im Falle der Mischung auf eine tiefere Frequenzebene werden LC-Verzögerungsleitungen eingesetzt. Das Oszillatorsignal, mit welchem das Ultraschallsignal gemischt wird, wird bei diesen beiden Lösungen für jeden Ultraschallkanal in der Phase eingestellt. Diese Einstellung wird gezielt so vorgenommen, daß die Phasenlagen der Träger der sich ergebenden gemischten Signale in allen Kanälen gleich sind. Durch Änderung der Phasenlage wird eine näherungsweise Feinverzögerung des Ultraschallsignals erreicht. Bei größeren Verzögerungszeiten wird dann in einem zweiten Schritt mittels analoger Verzögerungsleitungen das gemischte Signal eines jeden Kanals in solchen Schritten grob verzögert, die einem ganzzahligen Vielfachen der Periode T der Trägerschwingung des Ultraschallsignals entsprechen. Die Phasenlage der einzelnen gemischten Signale bleibt dabei konstant (Kohärenz). Nachteilig bei diesem Verfahren ist zum einen der konstruktive Aufwand, der beim Mischen der Signale anfällt. Zum anderen ist nachteilig, daß die Kohärenz der Phasen nur für eine einzelne Frequenz exakt herstellbar ist. Da das empfangene Ultraschallsignal aber eine gewisse Bandbreite aufweist, kommt es zu Ungenauigkeiten. Je breitbandiger das empfangene Ultraschallsignal ist, desto ungenauer arbeitet dieses Verfahren.

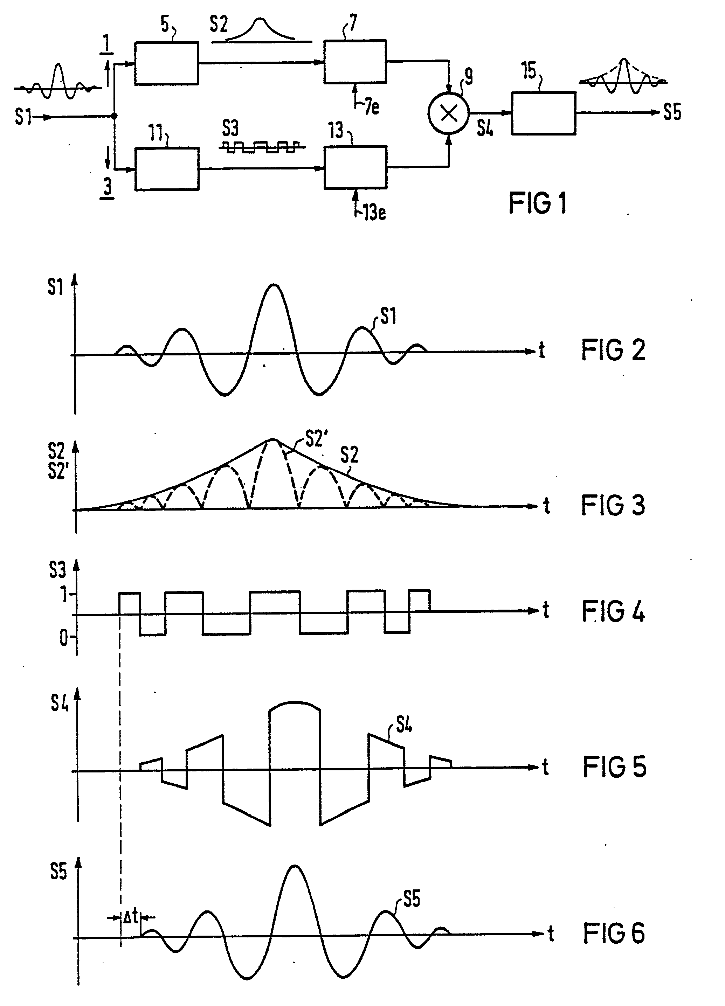

Bei der Technik nach G. F. Manes et al, supra, Fig. 1, erfolgt das Mischen nicht auf eine niedrigere Frequenz, sondern auf Frequenz 0. Es handelt sich also um das sogenannte Basisbandverfahren. Als Folge davon ist eine Quadraturverarbeitung des Signals erforderlich. Die dort angewandte Quadraturverarbeitung umfaßt zwei getrennte Verzögerungskanäle mit einer Vielzahl von Bauelementen, was die Lösung technisch sehr aufwendig macht und die Wirtschaftlichkeit des Verfahrens in Frage stellt.

In der französischen Patentschrift FR-A-2 131 551 ist eine Vorrichtung beschrieben, die ein betragskonstantes Ultraschallsignal verzögert. Darin wird aus dem zu verzögernden Signal sowohl ein Betragssignal als auch eine digitale Kurve, die das jeweilige Vorzeichen des Signals wiedergibt, ermittelt. Die digitale Kurve wird um den gewünschten Betrag verzögert und anschließend mit dem unverzögerten Betragssignal multiplikativ zusammengesetzt. Aus diesem zusammengesetzten Signal wird das verzögerte Signal nach Tiefpaßfilterung gewonnen. Mit dieser Vorrichtung können jedoch keine Ultraschallsignale verzögert werden, deren Hüllkurve sich zeitlich ändert.

Es soll noch betont werden, daß Verzögerungsbauelemente, deren Verzögerungszeit in einem größeren Bereich einstellbar sind, entweder für gewisse Frequenzbereiche überhaupt nicht erhältlich oder aber äußerst kostspielig sind.

Aufgabe der Erfindung ist es, ein Verfahren zur Verzögerung von Ultraschallsignalen anzugeben, das mit wenigen und technisch wenig aufwendigen Bauelementen auskommt und das außerdem zum Verzögern eines relativ breitbandigen Ultraschallsignals geeignet ist. Weiterhin ist es Aufgabe der Erfindung, eine Vorrichtung zur Durchführung des Verfahrens anzugeben.

Diese Aufgabe wird erfindungsgemäß dadurch gelöst, daß aus dem Ultraschallsignal eine Betragshüllkurve ermittelt und diese anschließend verzögert wird, daß aus dem Ultraschallsignal auch eine digitale Kurve, welche das jeweilige Vorzeichen des Ultraschallsignals wiedergibt, erzeugt wird, daß die digitale Kurve zumindest näherungsweise um denselben Wert verzögert wird wie die Betragshüllkurve, und daß die verzögerte digitale Kurve und die verzögerte Betragshüllkurve zu einem Zwischensignal multiplikativ zusammengesetzt werden, aus welchem das verzögerte Ultraschallsignal durch Tiefpaßfilterung ableitbar ist.

Eine Vorrichtung zur Durchführung des Verfahrens zeichnet sich dadurch aus daß das Ultraschallsignal gleichzeitig einem ersten und einem zweiten Kanal zugeführt ist, daß im ersten Kanal ein Betrags-Hüllkurvenbildner und eine diesem nachgeschaltete erste Verzögerungseinrichtung angeordnet sind, daß im zweiten Kanal eine Einrichtung zur Vorzeichenbildung und eine dieser nachgeschalteten zweite Verzögerungseinrichtung angeordnet sind, und daß beide Kanäle ausgangsseitig an ein Multiplizierglied angeschlossen sind, dem ein Tiefpaßfilter nachgeschaltet ist.

Die aus dem ursprünglichen Ultraschallsignal gebildete Betragshüllkurve hat Frequenzanteile von Null bis ca. 1 MHz. Damit ist sie gut geeignet, mit einer der bekannten digitalen Verzögerungstechniken oder über LC-Verzögerungsleitungen verzögert zu werden. Analog-Digital-Wandler, die mit einer Abtastrate von 3 bis 4 MHz arbeiten, sind wesentlich billiger und arbeiten zudem noch genauer als Analog-Digital-Wandler, die mit 15 bis 20 MHz abtasten. Die Betragshüllkurvenbildung des Ultraschallsignals stellt technisch kein größeres Problem dar. Im einfachsten Fall kann sie angenähert durch einen Gleichrichter mit nachgeschaltetem Tiefpaßfilter vorgenommen werden. Dies ist die bevorzugte Ausführungsform. Etwas aufwendiger und auch genauer kann die Betrags-Hüllkurvenbildung über eine Quadraturdemodulation vorgenommen werden. Auch dieses Quadraturverfahren benötigt einen verhältnismäßig kleinen Aufwand. Es ist als solches bereits im Stande der Technik zufriedenstellend gelöst. Die Verzögerung der Betragshüllkurve kann wegen der geringen Bandbreite (langsame Änderung im Kurvenverlauf) in verhältnismäßig großen Schritten erfolgen (Grobverzögerung).

Die Vorzeichenkurve läßt sich relativ einfach durch einen Spannungsvergleich mit der Spannung Null Volt ermitteln. Sie ist besonders einfach aufgebaut, da sie nur durch die beiden logischen Werte H und L gekennzeichnet zu werden braucht. Auch die Verzögerung der Vorzeichenkurve kann relativ einfach technisch realisiert werden. Die Vorzeichenkurve ist ein digitales Signal, welches sich z. B. mit Hilfe eines Schieberegisters in kleinen Schritten verzögern läßt (Feinverzögerung).

Weitere Ausgestaltungen und Vorteile der Erfindung ergeben sich aus den Figuren in Verbindung mit den Unteransprüchen. Es zeigen :

Fig. 1 ein Prinzipschaltbild zur getrennten Verzögerung von Betragshüllkurve und Vorzeichen eines Ultraschallsignals,

Fig. 2 bis 6 Signalverläufe, die an ausgewählten Punkten des Prinzipschaltbilds gemäß Figur 1 auftreten,

Fig. 7 eine erste Schaltung zur Betrags-Hüllkurvenbildung,

Fig. 8 eine zweite Schaltung zur Betrags-Hüllkurvenbildung und

Fig. 9 ein Prinzipschaltbild zur digitalen Verzögerung der Betragshüllkurve.

In Figur 1 ist ein Empfangskanal eines Phased-Array-Gerätes gezeigt, das zur medizinischen Abtastung eines Objekts eingesetzt wird. Danach wird ein Ultraschallsignal S1 auf einen Knotenpunkt geführt, von welchem ein erster Kanal 1 und ein zweiter Kanal 3 abzweigen. Der erste Kanal 1 enthält einen Betrags-Hüllkurvenbildner 5, dessen Ausgangssignal S2, das im folgenden als « Betragshüllkurve » bezeichnet wird, zu einer ersten Verzögerungseinrichtung 7 weitergeleitet wird. Das hier verzögerte Ausgangssignal S2 wird als erste Eingangsgröße einem Multiplikator 9 zugeführt. Der zweite Kanal 3 enthält einen Vorzeichenbildner 11, dessen Ausgangssignal eine digitale Vorzeichenkurve oder Signalkurve S3 ist. Die digitale Signalkurve S3 kann z. B. durch eine Folge von 1-bit-Signalen repräsentiert werden, wobei der Zustand 1 oder H dann Plus und der Zustand O oder L Minus bedeutet. Die digitale Signalkurve S3 wird über eine zweite Verzögerungseinrichtung 13 verzögert und anschließend als zweite Eingangsgröße dem Multiplikator 9 zugeführt. Der Multiplikator 9 liefert ein Ausgangssignal S4, welches durch Multiplikation des verzögerten Ausgangssignals S2 und der verzögerten Signalkurve S3 gebildet wird. Das Ausgangssignal S4 des Multiplikators 9 wird auf ein Tiefpaßfilter 15 gegeben. Am Ausgang des Tiefpaßfilters 15 steht ein Signal S5 zur Verfügung, welches das verzögerte Ultraschallsignal S1 repräsentiert. Dieses wird zusammen mit den verzögerten Ultraschallsignalen anderer Kanäle in einem nicht gezeigten Addierglied addiert. Wegen der Linearität der Addition ist es möglich und aus Aufwandsgründen vorteilhaft, anstelle eines Tiefpaßfilters 15 in jedem Empfangskanal ein gemeinsames Tiefpaßfilter nach dem Addierglied vorzusehen.

Ausführungsbeispiele des Betrags-Hüllkurvenbildners 5 werden später noch anhand der Figuren 3 und 4 näher erläutert. Der Vorzeichenbildner 11 kann z. B. ein Komparator sein, der sein eingangsseitig anliegendes Signal mit dem Wert O vergleicht. Ist der Wert größer als O, also positiv, legt der Komparator an seinen Ausgang eine 1 ; ist der Wert kleiner als O, also negativ, so legt der Komparator an seinen Ausgang den Wert O. Die erste Verzögerungseinrichtung 7 zur Verzögerung des Ausgangssignals S2 des Betrags-Hüllkurvenbildners 5 ist zur Verzögerung um grobe Zeitschritte in der Größenordnung von z. B. 500 ns ausgelegt. Die zweite Verzögerungseinrichtung 13, die die digitale Signalkurve S3 verzögert, ist zu einer Verzögerung in kleinen Schritten, wie z. B. in Schritten von 50 ns, ausgelegt. Der Multiplikator 9 und das Tiefpaßfilter 15 sind hier gängige Bauelemente.

In Figur 2 ist beispielshaft das Ultraschallsignal S1 in Abhängigkeit von der Zeit t dargestellt. Es besitzt in einem typischen Fall nach der Fourier-Zerlegung Frequenzanteile im Bereich von 3 bis 5 MHz. Das Ultraschallsignal S1 ist dabei das in einem Ultraschallempfänger registrierte und in ein elektrisches Signal umgewandelte Eingangssignal, welches zuvor an einer Grenzfläche, z. B. im Körper eines Patienten, reflektiert wurde. An den einzelnen Ultraschallwandler-Elementen eines Ultraschallapplikator (« Array ») treffen die Echos von einem bestimmten Zielpunkt des Objekts zeitlich nacheinander ein. Um diese in den verschiedenen Empfangskanälen zeitlich gestaffelt einlaufenden Signalverläufe S1 zur Zusammensetzung eines Ultraschallbildes verwenden zu können, müssen sie zeitgleich gemacht werden. Das heißt, daß früh einlaufende Ultraschallsignale S1 solange verzögert werden müssen, bis auch die spät einlaufenden Ultraschallsignale S1 anderer Empfangskanäle empfangen worden sind. Bei einer Betrachtung im Frequenzbereich bedeutet dies, daß die unterschiedlichen Phasenlagen der Ultraschallsignale S1 gleichgelegt, d. h. kohärent gemacht werden müssen, um eine Summation der Vielzahl an Ultraschallsignalen S1 durchführen zu können.

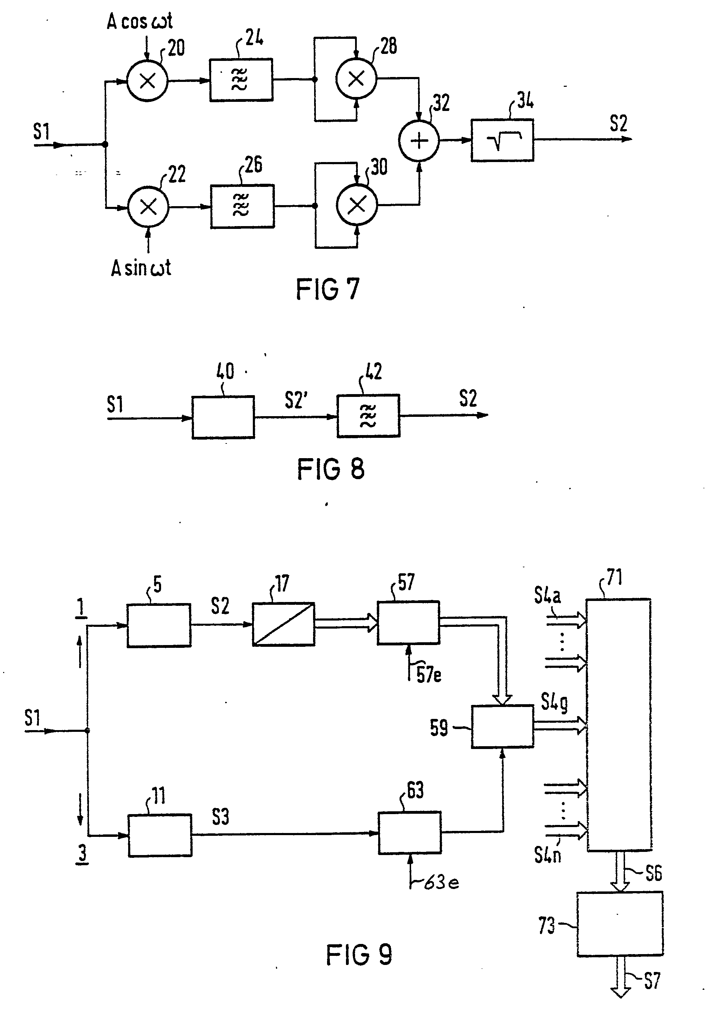

Zum Zwecke der Verzögerung wird das Ultraschallsignal S1 auf den ersten Kanal 1 und den zweiten Kanal 3 gegeben. Durch den Betrags-Hüllkurvenbildner 5, der im ersten Kanal 1 angeordnet ist, werden zunächst die negativen Anteile des Ultraschallsignals S1 in gleichhohe positive Anteile umgewandelt, d. h. es findet eine Gleichrichtung statt. Es entsteht so das Signal S2', welches in Figur 3 gestrichelt dargestellt ist. Der Betrags-Hüllkurvenbildner 5 beinhaltet gleichzeitig noch ein Tiefpaßfilter (in Fig. 8 gezeigt), mit dessen Hilfe aus dem gleichgerichteten Signal S2' das Ausgangssignal S2 gebildet wird. Dieses Ausgangssignal S2 ist gleich der Betragshüllkurve des Ultraschallsignals S1. Das Ausgangssignal S2 des Betrags-Hüllkurvenbildners 5 enthält im wesentlichen nur noch Frequenzanteile, die unter 1 MHz liegen. Es ist somit gut geeignet, mit einer der herkömmlichen erprobten Verzögerungseinrichtungen (wie z. B. LC-Verzögerungsleitungen oder mit digitalen Verzögerungstechniken) verzögert zu werden.

Figur 4 zeigt die digitale Signalkurve S3, die am Ausgang des Vorzeichenbildners 11 zur Verfügung steht. Ein Vorzeichenwechsel erfolgt dabei jedesmal an den Stellen, an denen das Ultraschallsignal S1 einen Nulldurchgang aufweist. Dies wird durch einen Vergleich mit den Diagrammen der Figuren 2 und 3 deutlich. Die digitale Signalkurve S3 wird der zweiten Verzögerungseinrichtung 13 zugeführt, welche z. B. ein gängiges Schieberegister ist. Die zweite Verzögerungseinrichtung 13 ist dabei — wie erwähnt — so eingerichtet, daß sie Verzögerungen in kleinen Schritten von z. B. 50 ns vornehmen kann. Die verzögerte digitale Signalkurve S3 wird zusammen mit dem verzögerten Ausgangssignal S2 des Betrags-Hüllkurvenbildners 5 auf den Multiplikator 9 gegeben. Figur 5 zeigt dabei das Ergebnis des Multiplikationsvorgangs, nämlich das Ausgangssignal S4 des Multiplikators 9. Nach der Glättung durch das Tiefpaßfilter 15 ergibt sich das Ausgangssignal S5 gemäß Figur 6, dessen Kurvenverlauf mit dem des Ultraschallsignals S1 gut übereinstimmt. Es ist jedoch gegenüber diesem um den Betrag Δt verzögert. Die Einstellung des Wertes Δt erfolgt an Einstellorganen 7e, 13e der Verzögerungseinrichtungen 7 und 13.

Die Verzögerung der digitalen Signalkurve S3 erfolgt in kleinen oder feinen Schritten, um die Anpassung der Phasenlage der von verschiedenen Ultraschallwandlern abgegebenen Ultraschallsignale S1 zu ermöglichen. Dadurch wird vermieden, daß sich empfangene Ultraschallsignale S1 in einem späteren Summiervorgang gegenseitig aufheben. Die schrittweise Verzögerung des Ausgangssignals S2 des Betrags-Hüllkurvenbildners 5 braucht diese Feinabstufung der Verzögerung nicht auszuführen, da sich der Verlauf des Ausgangssignals S2 innerhalb solch kleiner Zeitschritte (z. B. 50 ns) nur wenig ändert.

Das Verfahren soll an einem Zahlenbeispiel näher erläutert werden. Es sei angenommen, daß mit der Schaltung nach Fig. 1 eine Verzögerungszeit von 5,33 µs eingestellt werden soll. Weiterhin wird angenommen, daß die Betragshüllkurve S2 in Schritten von einer Schrittweite von 500 ns und das Vorzeichensignal S3 in Schritten von einer Schrittweite von 50 ns verzögert eingestellt werden kann. Die Einstellung an den beiden Verzögerungsgliedern 7 und 13 erfolgt nun so, daß sich jeweils die der gewünschten Verzögerungszeit von 5,33 µs am nächsten liegende Verzögerungszeit ergibt. Im Falle der Betragshüllkurve S2 werden somit 11 Schritte genommen, so daß sich eine Verzögerungszeit von 11 × 500 ns = 5,5 µs ergibt. Im Falle des Vorzeichensignals S3 werden somit 107 Schritte zu 50 ns eingestellt, so daß sich eine Verzögerungszeit von 107 × 50 ns = 5,35 µs ergibt. Die beiden Werte 5,5 µs und 5,35 µs stimmen recht gut mit dem gewünschten Wert 5,33 µs überein. Will man eine noch bessere Übereinstimmung erzielen, so kann man eine noch feinere Einteilung der Schritte bezüglich der Vorzeichenkurve S3 und gegebenenfalls auch der Betragshüllkurve S2 wählen. In diesem Zahlenbeispiel wurde ein Verhältnis der Schrittweiten von 500 ns/50 ns = 10 angenommen. In der Praxis wird man jedoch zweckmäßigerweise ein Verhältnis wählen, das im Bereich von 4 bis 8 liegt.

Experimente haben ergeben, daß man bei einer Frequenz von 3,5 MHz und einer Bandbreite von ca. 1 MHz mit einer Verzögerung der Betragshüllkurve S2 in Schritten von 700 ns auskommt, während die Vorzeichenkurve S3 in Schritten von 50 ns verzögert wird, um eine ausreichende Auflösung zu erzielen. Bei einer Frequenz von 5 MHz und einer Bandbreite von ca. 1,5 MHz kommt man mit entsprechenden Quantisierungsschritten von 500 ns bzw. 30 ns aus.

An den Einstellorganen 7e und 13e der Verzögerungseinrichtungen 7 bzw. 13 werden die Verzögerungszeiten schrittweise eingestellt. Diese Einstellung kann von einem entsprechend programmierten Steuergerät vorgenommen werden.

Figur 7 zeigt eine Schaltung, mit der das Ausgangssignal S2 des Betrags-Hüllkurvenbildners 5 gebildet werden kann. Das Ultraschallsignal S1 wird auf einen Knotenpunkt gegeben, von welchem zwei Abzweigungen wegführen. Das Signal S1 wird in Multiplikationsgliedern 20 und 22 mit zwei um 90° gegeneinander verschobenen Signalen, z. B. mit den Signalen A cos ωt bis A sin ωt, multipliziert, wobei ω = 2π/T, und T gleich oder ungefähr gleich der Periode der Trägerschwingung des Ultraschallsignals S1 ist. Die so erhaltenen Komponenten werden jeweils in einem Tiefpaßfilter 24 bzw. 26 gefiltert und anschließend in Quadriergliedern 28 bzw. 30 quadriert und sodann auf ein Summierglied 32 gegeben. Aus der Summe wird dann in einem Radizierglied 34 die Wurzel gezogen. Es wird also in bekannter Weise der Satz des Pythagoras schaltungsmäßig nachvollzogen.

Neben dieser Schaltung zur exakten Betrags-Hüllkurvenbildung durch Quadraturdemodulation kann auch die in Figur 8 dargestellte Schaltung, bestehend aus einem Gleichrichter 40 und einem nachfolgenden Tiefpaßfilter 42 angewendet werden. Diese Schaltung bedient sich also der Gleichrichtung und bewirkt eine näherungsweise Betragsbildung. Sie wurde schon bei Erläuterung der Fig. 3 zugrundegelegt.

Figur 9 zeigt eine Variante einer Verzögerung nach Betrag und Vorzeichen gemäß Fig. 1, wobei hier auch die Betragshüllkurve S2 digital verzögert wird. Das Ultraschallsignal S1 wird auf einen Knotenpunkt gegeben, von welchem ein erster Kanal 1 und ein zweiter Kanal 3 abzweigen. Im Verlauf des ersten Kanals 1 wird das Ultraschallsignal S1 an den Eingang eines Betrags-Hüllkurvenbildners 5 gelegt. Am Ausgang des Betrags-Hüllkurvenbildners 5 steht das Betragshüllkurven-Signal S2 zur Verfügung. Dieses analoge Signal S2 wird über einen Analog-Digital-Wandler 17 einer ersten Verzögerungseinrichtung 57 zugeführt. Die erste Verzögerungseinrichtung 57 ist hier zum Verzögern eines digitalen Signals eingerichtet. Es kann sich z. B. um ein Schieberegister handeln. Das so verzögerte digitale Signal wird an den ersten Eingang einer Invertiereinrichtung 59 gegeben. Diese entspricht dem Multiplizierglied 19 von Fig. 1.

Im Verlauf des zweiten Kanals 3 wird das Ultraschallsignal S1 einem Komparator 11 zugeführt. Dieser ermittelt durch Vergleich mit Spannung Null, ob das Ultraschallsignal S1 positiv oder negativ ist. Ist das Ultraschallsignal S1 positiv, legt der Komparator 11 an seinen Ausgang eine logische 1 ; und ist das Ultraschallsignal S1 negativ, so legt der Komparator 11 an seinen Ausgang das logische Signal O. Es wird also fortlaufend das Vorzeichen des Ultraschallsignals S1 gebildet. Die so entstandene digitale Kurve S3 wird einer zweiten Verzögerungseinrichtung 63 für feine Schritte zugeführt. Das dort verzögerte digitale Signal wird an den zweiten Eingang der Invertiereinrichtung 59 gegeben. Die Invertiereinrichtung 59 legt an ihren Ausgang jeweils den Wert, der an ihrem ersten Eingang anliegt, oder aber den dazu invertierten Wert. Ob der Wert unverändert bleibt oder invertiert wird, wird jeweils durch den Wert der digitalen Kurve S3 am zweiten Eingang bestimmt. Es entsteht so ein verzögerter Verlauf S4g des Ultraschallsignals S1 in digitaler Form. Zusammen mit weiteren ebenfalls auf die gleiche Art verzögerten Ultraschallsignalen S4a bis S4n wird das am Ausgang des Invertiergliedes 59 anliegende Signal auf ein Summierglied 71 gelegt. Dort wird ein Summensignal 56 gebildet, welches auf ein digitales Tiefpaßfilter 73 weitergegeben wird. Das so gefilterte Summensignal 57 wird zu einem Bildspeicher (nicht gezeigt) weitergegeben.

Die Einstellorgane für die Feinverzögerung (z. B. 50 ns) bzw. die Grobverzögerung (z. B. 500 ns) an den Verzögerungsgliedern 63 bzw. 57 sind mit 63e bzw. 57e bezeichnet.

Bei Figur 1 war die Summation der einzelnen verzögerten Signale zwar geschildert, aber nicht gezeigt. In Figur 9 ist diese nun in Einzelheiten dargestellt. In Figur 1 könnte dabei ein Tiefpaßfilter 73 nicht hinter dem Additionsglied 71 angeordnet, sonder in jedem Empfangskanal einzeln untergebracht sein.

## Patentansprüche

1. Verfahren zur Verzögerung eines aus einem Trägersignal mit zugeordneter Hüllkurve bestehenden Ultraschallsignals, das folgende Schritte umfaßt :

- aus dem Ultraschallsignal wird eine Betragshüllkurve und eine digitale Kurve, welche das jeweilige Vorzeichen des Ultraschallsignals wiedergibt, ermittelt,

- die digitale Kurve wird um einen Wert verzögert,

- die verzögerte digitale Kurve und die Betrags-

hüllkurve werden zu einem Zwischensignal multiplikativ zusammengesetzt, aus welchem das verzögerte Ultraschallsignal durch Tiefpaßfilterung ableitbar ist, dadurch gekennzeichnet, daß die Betragshüllkurve (S2) vor der Multiplikation zumindest näherungsweise um denselben Wert (Δt) verzögert wird wie die digitale Kurve (S3).

2. Verfahren nach Anspruch 1, dadurch gekennzeichnet, daß die Bildung der Betragshüllkurve (S2) durch Quadraturdemodulation des Ultraschallsignals (S1) vorgenommen wird (Fig. 7).

3. Verfahren nach Anspruch 1, dadurch gekennzeichnet, daß die Bildung der Betragshüllkurve (S2) durch Gleichrichtung und Tiefpaßfilterung des Ultraschallsignals (S1) vorgenommen wird (Fig. 8).

4. Verfahren nach einem der Ansprüche 1 bis 3, dadurch gekennzeichnet, daß die digitale Kurve (S3) durch Vergleich des Ultraschallsignals (S1) mit einem Nullsignal ermittelt wird.

5. Verfahren nach einem der Ansprüche 1 bis 4, dadurch gekennzeichnet, daß die Verzögerung der Betragshüllkurve (S2) analog erfolgt (Fig. 1).

6. Verfahren nach einem der Ansprüche 1 bis 4, dadurch gekennzeichnet, daß die Betragshüllkurve (S2) digitalisiert und anschließend digital verzögert wird (Fig. 9).

7. Verfahren nach einem der Ansprüche 1 bis 6, dadurch gekennzeichnet, daß mehrere Ultraschallsignale unterschiedlich verzögert und anschließend summiert werden (Fig. 9).

8. Verfahren nach einem der Ansprüche 1 bis 7, dadurch gekennzeichnet, daß die digitale Kurve (S3) in Schritten mit vorgegebener erster Schrittweite verzögert wird, daß die Betragshüllkurve (S2) in Schritten mit vorgegebener zweiter Schrittweite verzögert wird, und daß die erste Schrittweite kleiner ist als die zweite Schrittweite.

9. Vorrichtung zur Durchführung des Verfahrens nach Anspruch 1, dadurch gekennzeichnet, daß das Ultraschallsignal (S1) gleichzeitig einem ersten und einem zweiten Kanal (1, 3) zugeführt ist, daß im ersten Kanal (1) ein Betrags-Hüllkurvenbildner (5) und eine diesem nachgeschaltete erste Verzögerungseinrichtung (7 ; 57) angeordnet sind, daß im zweiten Kanal (3) eine Einrichtung (11) zur Vorzeichenbildung und eine dieser nachgeschaltete zweite Verzögerungseinrichtung (13 ; 63) angeordnet sind, und daß beide Kanäle (1, 3) ausgangsseitig an ein Multiplizierglied (9 ; 59) angeschlossen sind, dem ein Tiefpaßfilter (15 ; 73) nachgeschaltet ist (Fig. 1 ; Fig. 9).

10. Vorrichtung nach Anspruch 9, dadurch gekennzeichnet, daß der Betrags-Hüllkurvenbildner (5) eine Schaltung zur Quadraturdemodulation ist (Fig. 7).

11. Vorrichtung nach Anspruch 9, dadurch gekennzeichnet, daß der Betrags-Hüllkurvenbildner (5) eine Gleichrichterschaltung (40) mit nachgeschaltetem Tiefpaßfilter (42) enthält (Fig. 8).

12. Vorrichtung nach einem der Ansprüche 9 bis 11, dadurch gekennzeichnet, daß die erste Verzögerungseinrichtung (7) zur analogen Verzögerung der Betragshüllkurve (S2) eingerichtet ist (Fig. 1).

13. Vorrichtung nach einem der Ansprüche 9 bis 12, dadurch gekennzeichnet, daß die Einrichtung (11) zur Vorzeichenbildung ein Komparator ist, der einen Vergleich mit dem Wert Null durchführt (Fig. 1, 9).

14. Vorrichtung nach einem der Ansprüche 9 bis 13, dadurch gekennzeichnet, daß die zweite Verzögerungseinrichtung (13 ; 63) zur digitalen Verzögerung eingerichtet ist (Fig. 1, 9).

15. Vorrichtung nach einem der Ansprüche 9 bis 14, ausgenommen Anspruch 12, dadurch gekennzeichnet, daß im ersten Kanal (1) ein Analog-Digital-Wandler (17) vor der ersten Verzögerungseinrichtung (57) angeordnet ist, und daß die erste Verzögerungseinrichtung (57) zur digitalen Verzögerung eingerichtet ist (Fig. 9).

16. Vorrichtung nach einem der Ansprüche 9 bis 15, dadurch gekennzeichnet, daß die erste Verzögerungseinrichtung (7 ; 57) und die zweite Verzögerungseinrichtung (13 ; 63) jeweils ein Einstellorgan (7e, 57e bzw. 13e, 63e) zur schrittweisen Einstellung von Verzögerungszeiten aufweisen.

17. Vorrichtung nach Anspruch 16, dadurch gekennzeichnet, daß an die Einstellorgane eine programmierbare Steuereinheit angeschlossen ist.

## Claims

1. Method for delaying an ultrasound signal comprising a carrier signal with associated envelope, comprising the following steps :
- from the ultrasound signal an absolute-value envelope and a digital curve reproducing the particular sign of the ultrasound signal is determined,
- the digital curve is delayed by a value,
- the delayed digital curve and the absolute-value envelope are multiplicatively combined into an intermediate signal, from which the delayed ultrasound signal can be derived by low-pass filtering, characterised in that before multiplication the absolute-value envelope (S2) is delayed at least approximately by the same value (Δt) as the digital curve (S3).

2. Method according to Claim 1, characterised in that the formation of the absolute-value envelope (S2) is performed by quadrature demodulation of the ultrasound signal (S1) (Fig. 7).

3. Method according to Claim 1, characterised in that the formation of the absolute-value envelope (S2) is performed by rectification and low-pass filtering of the ultrasound signal (S1) (Fig. 8).

4. Method according to one of Claims 1 to 3, characterised in that the digital curve (S3) is determined by comparison of the ultrasound signal (S1) with a zero signal.

5. Method according to one of Claims 1 to 4, characterised in that the delay of the absolute-value envelope (S2) is performed by analogue means (Fig. 1).

6. Method according to one of Claims 1 to 4, characterised in that the absolute-value envelope (S2) is digitised and then delayed using digital means (Fig. 9).

7. Method according to one of Claims 1 to 6, characterised in that a plurality of ultrasound signals are delayed in different ways and then summed (Fig. 9).

8. Method according to one of Claims 1 to 7, characterised in that the digital curve (S3) is delayed in steps with a preset first step size, that the absolute-value envelope (S2) is delayed in steps with a preset second step size, and that the first step size is smaller than the second step size.

9. Apparatus for carrying out the method according to Claim 1, characterised in that the ultrasound signal (S1) is simultaneously fed to a first and a second channel (1, 3), that in the first channel (1) are located an absolute-value envelope former (5) followed by a first delay device (7 ; 57), that in the second channel (3) are located a device (11) for sign formation followed by a second delay device (13 ; 63), and that both channels (1, 3) are connected on the output side to a multiplication member (9 ; 59) to which a low-pass filter (15 ; 73) is connected (Fig. 1; Fig. 9).

10. Apparatus according to Claim 9, characterised in that the absolute-value envelope former (5) is a quadrature demodulation circuit (Fig. 7).

11. Apparatus according to Claim 9, characterised in that the absolute-value envelope former (5) contains a rectifier circuit (40) with a low-pass filter (42) connected thereto (Fig. 8).

12. Apparatus according to one of Claims 9 to 11, characterised in that the first delay device (7) is set up for analogue delay of the absolute-value envelope (S2) (Fig. 1).

13. Apparatus according to one of Claims 9 to 12, characterised in that the device (11) for sign formation is a comparator which performs a comparison with the value zero (Fig. 1, 9).

14. Apparatus according to one of Claims 9 to 13, characterised in that the second delay device (13 ; 63) is set up for digital delay (Fig. 1, 9).

15. Apparatus according to one of Claims 9 to 14, with the exception of Claim 12, characterised in that in the first channel (1) an analogue-to-digital converter (17) is arranged in front of the first delay device (57), and that the first delay device (57) is set up for digital delay (Fig. 9).

16. Apparatus according to one of Claims 9 to 15, characterised in that the first delay device (7 ; 57) the second delay device (13 ; 63) each have an adjustment element (7e, 57e, and 13e, 63e, respectively) for stepwise adjustment of delay times.

17. Apparatus according to Claim 16, characterised in that a programmable control unit is connected to the adjustment elements.

## Revendications

1. Procédé pour retarder un signal ultrasonore constitué par un signal de porteuse, auquel est associée une courbe enveloppe, ce procédé incluant les étapes suivantes :
- on détermine, à partir du signal ultrasonore, une courbe enveloppe de valeurs et une courbe numérique, qui reproduit le signe respectif du signal ultrasonore,
- on retarde la courbe enveloppe d'une certaine valeur,
- on réunit par multiplication la courbe numérique retardée et la courbe enveloppe de valeurs pour former un signal intermédiaire, à partir duquel on peut obtenir le signal ultrasonore retardé par filtrage dans un filtre passe-bas, caractérisé par le fait qu'on retarde la courbe enveloppe de valeurs (S2), avant la multiplication, au moins approximativement de la même valeur ($\Delta t$) que la courbe numérique (S3).

2. Procédé suivant la revendication 1, caractérisé par le fait qu'on forme la courbe enveloppe de valeurs (S2) au moyen d'une démodulation en quadrature du signal ultrasonore (S1) (figure 7).

3. Procédé suivant la revendication 1, caractérisé par le fait qu'on forme la courbe enveloppe de valeurs (S2) par redressement et filtrage, dans un filtre passe-bas, du signal ultrasonore (S1) (figure 8).

4. Procédé suivant l'une des revendications 1 à 3, caractérisé par le fait qu'on détermine la courbe enveloppe (S3) par comparaison du signal ultrasonore (S1) à un signal nul.

5. Procédé suivant l'une des revendications 1 à 4, caractérisé par le fait que le retard de la courbe enveloppe de valeurs (S2) s'effectue sous forme analogique (figure 1).

6. Procédé suivant l'une des revendications 1 à 4, caractérisé par le fait qu'on numérise la courbe enveloppe (S2) et qu'on la retarde ensuite de façon numérique (figure 9).

7. Procédé suivant l'une des revendications 1 à 6, caractérisé par le fait qu'on retarde différemment plusieurs signaux ultrasonores et qu'on en effectue ensuite la sommation (figure 9).

8. Procédé suivant l'une des revendications 1 à 7, caractérisé par le fait qu'on retarde la courbe numérique (S3) selon des pas possédant une première durée prédéterminée, qu'on retarde la courbe enveloppe de valeurs (S2) selon des pas possédant une seconde durée prédéterminée, et que la première durée de pas est inférieure à la seconde durée de pas.

9. Dispositif pour la mise en oeuvre du procédé suivant la revendication 1, caractérisé par le fait que le signal ultrasonore (S1) est envoyé simultanément à des premier et second canaux (1, 3), qu'un dispositif (5) de formation de la courbe enveloppe de valeurs et un premier dispositif de retard (7 ; 57), branché en aval du dispositif précédent, sont disposés dans le premier canal (1), qu'un dispositif (11) de formation du signe et un second dispositif de retard (13 ; 63), monté en aval du dispositif précédent, sont disposés dans le second canal (3), et que les deux canaux (1, 3) sont raccordés, côté sortie, à un circuit multiplicateur (9 ; 59), en aval duquel est branché un filtre passe-bas (15 ; 73) (figure 1 ; figure 9).

10. Dispositif suivant la revendication 9, caractérisé par le fait que le dispositif (5) de formation de la courbe enveloppe de valeurs est un circuit servant à réaliser la démodulation en quadrature (figure 7).

11. Dispositif suivant la revendication 9, caractérisé par le fait que le dispositif (5) de formation de la courbe enveloppe de valeurs contient un circuit redresseur (40), en aval duquel est branché un filtre passe-bas (42) (figure 8).

12. Dispositif suivant l'une des revendications 9 à 11, caractérisé par le fait que le premier dispositif de retard (7) est agencé de manière à réaliser le retard analogique de la courbe enveloppe de valeurs (S2) (figure 1).

13. Dispositif suivant l'une des revendications 9 à 12, caractérisé par le fait que le dispositif (11) de formation du signe est un comparateur, qui réalise une comparaison par rapport à la valeur zéro (figures 1, 9).

14. Dispositif suivant l'une des revendications 9 à 13, caractérisé par le fait que le second dispositif de retard (13 ; 63) est agencé de manière à réaliser le retard numérique (figures 1, 9).

15. Dispositif suivant l'une des revendications 9 à 14, à l'exclusion de la revendication 12, caractérisé par le fait qu'un convertisseur analogique/numérique (17) est disposé en amont du premier dispositif de retard (57) dans le premier canal (1), et que le premier dispositif de retard (57) est agencé de manière à réaliser le retardement numérique (figure 9).

16. Dispositif suivant l'une des revendications 9 à 15, caractérisé par le fait que le premier dispositif de retard (7 ; 57) et le second dispositif de retard (13 ; 63) comportent chacun un élément de réglage (7e, 57e ou 13e ; 63e) servant à régler pas-à-pas des durées de retard.

17. Dispositif suivant la revendication 16, caractérisé par le fait qu'une unité de commande programmable est raccordée aux éléments de réglage.

FIG 1

FIG 2

FIG 3

FIG 4

FIG 5

FIG 6

FIG 7

FIG 8

FIG 9